Europäisches Patentamt

(19) European Patent Office

Office européen des brevets

(11) Numéro de publication: **0 433 147 A1**

(12) **DEMANDE DE BREVET EUROPEEN**

(21) Numéro de dépôt: 90403492.3

(22) Date de dépôt: 07.12.90

(51) Int. Cl.⁵: **H03F 1/30**

(30) Priorité: 15.12.89 FR 8916596

(43) Date de publication de la demande: 19.06.91 Bulletin 91/25

(84) Etats contractants désignés: **BE DE ES FR GB IT NL SE**

(71) Demandeur: **BULL S.A. 121, Avenue de Malakoff F-75116 Paris (FR)**

(72) Inventeur: **Neu, Georges 121 avenue de Malakoff F-75764 Paris Cédex 16 (FR)**

(74) Mandataire: **Denis, Hervé et al BULL S.A. Industrial Property Department P.C.: HQ 8M006 P.B. 193.16 121 avenue de Malakoff F-75764 Paris Cédex 16 (FR)**

(54) **Procédé et dispositif de compensation de la dérive en courant dans un circuit intégré MOS, et circuit intégré en résultant.**

(57) Dans l'inverseur (11) formé des transistors CMOS (P1 et N1), le dispositif de compensation (10a) relatif au transistor (P1) comprend un générateur (14) d'un signal de référence (Ra) représentatif de la conduction d'un transistor de référence (P2), deux amplificateurs à seuil (15t, 15f), deux interrupteurs (16t, 16f), et deux transistors de compensation (Pt, Pf). Si, à cause des dérives, les transistors de type P sont faibles, les interrupteurs sont actionnés sélectivement pour que les transistors (Pt, Pf) ajoutent un courant de compensation à celui fourni par le transistor (P1). Il en est de même pour le dispositif de compensation (10b) relatif au transistor (N1).

**FIG.1**

# PROCEDE ET DISPOSITIF DE COMPENSATION DE LA DERIVE EN COURANT DANS UN CIRCUIT INTEGRE MOS, ET CIRCUIT INTEGRE EN RESULTANT

L'invention se rapporte à un procédé et à un dispositif de compensation de la dérive en courant dans un circuit intégré de type MOS (Métal Oxyde Semiconducteur), et au circuit intégré en résultant.

L'invention s'applique notamment aux amplificateurs binaires, aux amplificateurs tampons et aux générateurs d'horloge.

On appelle circuit intégré une plaquette semiconductrice incorporant des circuits électroniques faits à base de transistors. L'invention s'applique plus particulièrement aux circuits intégrés de haute densité d'intégration, couramment appelés circuits VLSI (Very Large Scale Integration). Il est dit de type MOS quand il incorpore des transistors à effet de champ de ce type. Les transistors peuvent être tous à canal N (transistors N-MOS) ou tous à canal P (transistors P-MOS). L'association de ces transistors complémentaires est appelée CMOS. L'association de transistors à effet de champ de type MOS avec des transistors bipolaires est dite BiMOS ou BiCMOS.

La fabrication actuelle des circuits intégrés MOS ne permet pas d'obtenir des transistors MOS ayant sensiblement les caractéristiques courant/tension désirées dans tous les circuits intégrés. Pour diverses raisons, des transistors conçus pour avoir les mêmes caractéristiques présentent des dérives importantes entre les circuits intégrés. Pour une même tension, le courant en régime de saturation de transistors physiquement identiques peut varier d'un rapport supérieur à trois. Cependant, les caractéristiques de transistors identiques sont sensiblement les mêmes dans un même circuit intégré. On distingue ordinairement les transistors typiques ayant les caractéristiques prévues, les transistors puissants traversés par un plus fort courant que celui prévu, et les transistors faibles traversés par un courant plus faible. En d'autres termes, la dérive en courant est ordinairement positive ou négative par rapport au courant prévu.

Cette dérive a des conséquences indésirables. Supposons par exemple le cas courant dans un circuit intégré qu' un transistor MOS est commandé pour charger ou décharger un bus extérieur ou une ligne interne. Le bus a une inductance L qui conditionne le bruit en fonction de la variation du courant Ib qui traverse le bus. Le bruit correspond au produit L dIb/dt. L'inductance L a une valeur prédéterminée. Pour un bus externe, elle inclut l'inductance des parties de bus dans les boîtiers émetteurs et récepteurs, et l'inductance de la liaison entre les deux boîtiers. La valeur du bruit maximal admissible impose donc l'intensité maximale du courant Ib. Cette intensité détermine le dimensionnement du transistor correspondant. Supposons que la charge ou la décharge du bus faite par ce transistor déclenche un dispositif à seuil, un inverseur à seuil par exemple. L'inverseur sera déclenché à l'instant prévu par un transistor typique, à un instant plus court par un transistor puissant et à un instant plus long par un transistor faible. Cependant, la détermination d'une durée maximale s'impose couramment pour que les opérations dans le circuit intégré s'effectuent dans des temps déterminés par un signal d'horloge. Si le déclenchement a lieu après la durée maximale imposée, le fonctionnement est perturbé et introduit des processus de correction. La solution consistant à accroître le courant d'un transistor faible en augmentant ses dimensions est impossible. Dans un circuit intégré à transistors puissants, cette augmentation se traduirait par un courant dépassant la valeur maximale admissible et produirait un bruit excessif. D'autre part, l'évolution exige des circuits toujours plus rapides. La rapidité de fonctionnement serait améliorée s'il était possible de réduire de façon efficace et fiable la durée maximale de la commande d'un élément fonctionnel du circuit intégré, sans augmentation du bruit.

L'invention a pour but de faire fonctionner un circuit électronique dans des conditions optimales, indépendamment des dérives du courant des transistors MOS dans les divers circuits intégrés fabriqués. Elle a aussi pour but de ne pas augmenter le bruit. Un autre but est de réduire au maximum les durées d'attente d'un événement, afin d'améliorer de façon efficace et fiable la rapidité de fonctionnement d'un circuit intégré.

L'invention a d'abord pour objet un procédé de compensation de la dérive du courant d'un transistor à effet de champ dans un circuit intégré, caractérisé en ce qu'il consiste à produire un signal de référence représentatif de la conduction d'un transistor de référence du circuit intégré, à définir un seuil de conduction, à comparer le signal de référence avec le seuil de conduction, et à produire un courant de compensation si le signal de référence n'atteint pas le seuil de conduction.

En corollaire, un dispositif conforme à l'invention de compensation de la dérive du courant d'un transistor à effet de champ dans un circuit intégré est caractérisé en ce qu'il comprend : un commutateur ; et un circuit de compensation comprenant au moins un chemin de courant parallèle à celui du transistor à effet de champ et sélectionné par le commutateur.

Il en résulte un circuit intégré, caractérisé en ce qu'il comprend un dispositif de compensation tel que décrit précédemment.

Les caractéristiques et avantages de l'invention ressortent clairement de la description qui suit, donnée à titre d'exemple et faite en référence aux dessins annexés.

Dans les dessins :
- la figure 1 illustre schématiquement un inverseur de type CMOS associé à un dispositif de compensation conforme à l'invention ; et
- la figure 2 illustre schématiquement un interrupteur CMOS associé à un amplificateur pour le dispositif de compensation représenté sur la figure 1.

Dans les figures, les transistors N-MOS seront désignés par N et les transistors P-MOS par P.

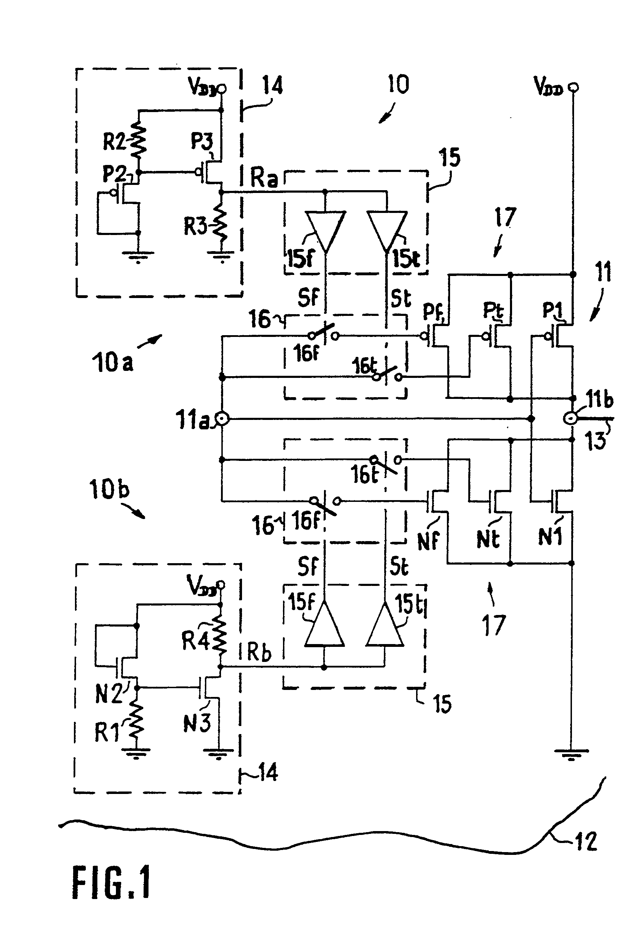

La figure 1 illustre schématiquement un dispositif de compensation 10 conforme à l'invention, associé à un inverseur 11 dans un circuit intégré 12 de type CMOS, représenté partiellement. L'inverseur 11 a ordinairement une entrée 11a et une sortie 11b. La sortie 11b est connectée à un bus 13. Un inverseur classique est fait de deux transistors complémentaires N1 et P1 montés en série entre la masse et la tension d'alimentation VDD. Quand l'entrée 11a a l'état logique "0" correspondant au potentiel de masse, le transistor N1 est bloqué et le transistor P1 conduit. Le bus 13 se charge à la tension VDD. Quand l'entrée 11a prend l'état "1" correspondant à la tension VDD, le transistor P1 est bloqué et le transistor N1 conduit. Le bus 13 se décharge à travers le transistor N1. Le dimensionnement des transistors N1 et P1 dans leur état typique correspond à l'intensité maximale admissible du courant dans le bus. Ces transistors détermine la durée typique de charge ou de décharge du bus. Si par exemple le transistor N1 est puissant, la durée de décharge sera plus courte, mais un inverseur classique formé des deux transistors N1 et P1 n'en tire aucun profit. Si le transistor N1 est faible, la durée de décharge est plus longue et risque d'être trop longue pour un fonctionnement normal. Il en est de même pour la durée de charge du bus 13 à travers le transistor P1. Les transistors à effet de champ de types complémentaires ayant des caractéristiques différentes, leurs dérives peuvent être différentes. Par exemple, il est possible que sur un même circuit intégré les transistors à canal N soient puissants et que les transistors à canal P soient faibles. Il en résulte une situation compliquée et défavorable à la rapidité recherchée du fonctionnement d'un inverseur pour tout circuit intégré.

L'invention associe à l'inverseur 11 le dispositif de compensation 10 qui va maintenant être décrit. Le dispositif de compensation 10 se compose de deux sections 10a, 10b s'appliquant respectivement aux transistors P1 et N1 de l'inverseur 11. Dans ces deux sections, les éléments communs portent les mêmes chiffres de référence. Chaque section comprend : un générateur de référence 14 produisant un signal de référence R (Ra, Rb) ; un générateur de seuil 15 composé de deux amplificateurs à seuil 15t et 15f présentant des seuils respectifs Tt et Tf ; un commutateur 16 composé de deux interrupteurs 16t et 16f ; et un circuit de compensation 17 composé de deux chemins de courant constitués par les trajets drain-source de deux transistors Pt et Pf dans la section 10a, et de deux transistors Nt et Nf dans la section 10b.

Le générateur de référence 14 de la section 10a comprend deux transistors P2, P3 ayant respectivement leurs trajets drain - source mis en série avec deux résistances R2, R3 entre la masse et le potentiel VDD. Le transistor P2 a son drain et sa grille à la masse. Sa source est reliée au potentiel VDD par l'intermédiaire de la résistance R2 et est appliquée sur la grille du transistor P3. Le transistor P3 a sa source connectée au potentiel VDD et son drain mis à la masse à travers la résistance R3. La sortie du générateur de référence 14 est le drain du transistor P3, qui délivre le signal de référence Ra. Ce signal est appliqué sur les entrées respectives des amplificateurs à seuil 15t et 15f. Les signaux de compensation St et Sf à la sortie des amplificateurs à seuil commandent respectivement les deux interrupteurs 16t et 16f. Chaque interrupteur est représenté schématiquement sur la figure 1 par un contact mécanique pour la commodité de lecture des dessins. Les interrupteurs 16t et 16f ont une borne connectée à l'entrée 11a de l'inverseur 11 et une autre borne connectée aux grilles respectives des transistors Pt et Pf. Ces transistors ont leurs trajets drain - source montés en parallèle sur celui du transistor P1.

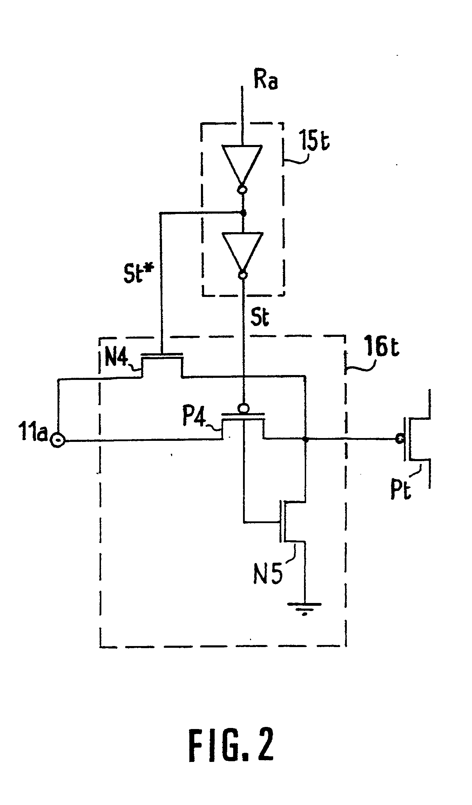

La figure 2 illustre un mode réalisation classique d'un interrupteur CMOS pouvant être employé pour constituer les interrupteurs 16t et 16f dans la section 10a. Elle se rapporte à titre illustratif à l'interrupteur 16t associé à l'amplificateur 15t. L'amplificateur 15t est classiquement fait d'un inverseur à seuil délivrant le signal de compensation complémentaire St*, suivi d'un inverseur délivrant le signal St. L'interrupteur 16t se compose de trois transistors P4, N4 et N5. Les transistors P4 et N4 ont leur trajet drain - source en parallèle entre l'entée 11a et la grille du transistor Pt et sont commandés respectivement par les signaux St et St*. Le transistor N5 a sa source à la masse, son drain connecté à la grille du transistor Pt, et sa grille recevant le signal St.

Le fonctionnement de la section 10a du dispositif de compensation 10 va maintenant être décrit. Dans le générateur de référence 14, il est avantageux d'établir une corrélation entre les dispersions en courant des transistors et les dispersions des résistances. Les résistances R2 et R3 sont de préférence faites en silicium polycristallin de façon que la dispersion des résistances soient négligeables par rapport à celles des transistors. Le transistor P2, avec sa grille connectée à son drain, constitue une diode. Le point de fonctionnement de la diode est déterminé par la valeur de la résistance R2. L'ensemble P2, R2 constitue le circuit de polarisation du transistor P3. Ce transistor amplifie les variations du courant dans le transistor P2. Si le courant du transistor P2 est faible, la tension sur sa source est élevée. Le transistor P3 est donc peu conducteur, de sorte que le signal de référence Ra sur son drain sera faible. Au contraire, si le transistor P2 est puissant, le signal de référence Ra sera élevé.

Le signal de référence Ra est ensuite comparé avec les seuils Tt et Tf des amplificateurs 15t et 15f. Une valeur de Ra égale ou inférieure au seuil Tf caractérise des transistors P-MOS faibles dans le circuit intégré 12. Une valeur de Ra supérieure au seuil Tf, mais égale ou inférieure au seuil Tt, caractérise l'existence de transistors typiques. Au-delà du seuil Tt, les transistors sont considérés comme puissants. Dans ce dernier cas, les deux amplificateurs 15t et 15f ne réagissent pas au signal de référence Ra. Leurs signaux de sortie ont l'état logique "0" et laissent les interrupteurs 16t et 16f à l'état ouvert. Il s'ensuit que seul le transistor P1, considéré comme puissant, conduit dans l'inverseur 11 si le signal sur l'entrée 11a a l'état "0". Si le signal de référence Ra indique la présence de transistors P-MOS typiques, seul l'amplificateur 15t est actif. Ses signaux de sortie St et St*, représentés sur la figure 2, ferme l'interrupteur 16t. Le transistor Pt reçoit alors le signal de l'entrée 11a de l'inverseur 11. Si ce signal a l'état "0", les transistors P1 et Pt conduisent. Si le signal de référence Ra correspond à des transistors faibles, les deux amplificateurs 15t et 15f sont actifs et font conduire les transistors Pt et Pf en plus du transistor P1 si l'entrée 11a a l'état "0".

Le procédé conforme à l'invention consiste donc à produire un signal de référence Ra représentatif de la conduction du transistor de référence P2 du circuit intégré 12, à définir un seuil de conduction Tt, à comparer le signal de référence avec le seuil de conduction, et à produire un courant de compensation si le signal de référence n'atteint pas le seuil de conduction. Dans l'exemple précédent, un deuxième seuil de conduction Tf améliore les performances du procédé. En outre, la production du courant de compensation consiste à ajouter au courant du transistor à effet de champ P1 un courant additionnel.

Une autre caractéristique de l'invention consiste à déterminer l'intensité du courant de compensation. A titre d'illustration, on désignera les intensités moyennes respectives des transistors puissants, typiques et faibles par Ip, It et If. et on supposera que d'après les statistiques $Ip = 3It/2$ et que $If = 2It/3$. Autrement dit, $It = 1,5.If$ et $Ip = 2,25.If$. En dimensionnant les transistors Pt et Pf pour être traversés par un même courant valant la moitié de celui traversant le transistor P1, l'intensité Ib du courant dans le bus 13 est égale à Ip pour des transistors puissants dans la section 10a ; pour des transistors typiques, $Ib = It+It/2 = 3It/2$ ; et pour des transistors faibles, $Ib = If+If/2+If/2 = 2$ If. Compte tenu des suppositions précédentes, ces égalités deviennent : pour des transistors puissants, $Ib = 2,25.If$ ; pour des transistors typiques, $Ib =$ $2,25.If$ ; et pour des transistors faibles, $Ib = 2.If$. La détermination judicieuse du courant traversant les transistors Pt et Pf aboutit donc au passage d'un courant sensiblement constant dans le bus 13, indépendamment des dérives en courant des transistors P-MOS dans le circuit intégré 12.

La section 10b du dispositif de compensation 10 applique le même principe aux transistors N-MOS du circuit intégré 12. En bref, le générateur de référence 14 comprend deux transistors N2 et N3 et deux résistances R1, R4. Le transistor N2 a son drain et sa grille connectés au potentiel VDD. Sa source est mise à la masse à travers la résistance R1 et est appliquée sur la grille du transistor N3. Le transistor N3 a sa source à la masse et son drain relié au potentiel VDD par l'intermédiaire de la résistance R4. Le signal de référence Rb sur le drain du transistor N3 est appliquée sur les entrées des deux amplificateurs à seuil 15t et 15f. Leurs signaux de sortie St, St* et Sf, Sf* commandent l'actionnement des deux interrupteurs 16t et 16f relatifs aux transistors de compensation Nt et Nf.

De nombreuses variantes peuvent être apportées à l'exemple décrit. Notamment, un seul seuil peut dans certains cas suffire. Au contraire, d'autres peuvent s'y ajouter. D'autre part, les courants de compensation dans l'exemple décrit s'ajoutent et ont une action cumulative avec le courant principal dans P1 ou N1. Cependant, la commutation pourrait être non cumulative. Par exemple, le commutateur 16 pourrait déconnecter le transistor P1 et connecter le transistor Pt dimensionné pour conduire un courant $Ib = 2,25.If$. Un autre mode de réalisation du procédé conforme à l'invention pourrait aussi consister à supprimer les générateurs de référence 14. Le procédé consisterait, avant l'utilisation du circuit intégré 12, à mesurer le courant traversant un transistor P-MOS et un transistor N-MOS du circuit intégré, et à le comparer avec au moins un seuil. Le résultat de la comparaison pourrait être introduit dans un registre du circuit intégré. Le contenu du registre serait représentatif du signal de compensation. Il serait introduit lors de l'initialisation du système de traitement du circuit intégré. Le résultat de la comparaison pourrait aussi être introduit dans une mémoire morte effaçable, par exemple. Plus simplement, le dispositif de compensation 10 pourrait n'inclure que les circuits de compensation 17 et les commutateurs 16 qu'on fermerait sélectivement par laser par exemple.

L'invention présente l'avantage d'égaliser le courant dans le bus 13 sur la meilleure intensité possible. L'inverseur 11 offre ainsi les meilleures performances possibles, indépendamment des dérives en courant de ses transistors. Il en résulte ainsi une amélioration importante du temps de propagation. Comme ce temps est pratiquement constant, le circuit intégré 12 peut fonctionner plus rapidement. Cet avantage est obtenu sans augmentation du bruit représentatif de la composante selfique du bus. Ce bruit est connu communément sous le terme "slew rate". En outre, la régulation du temps de montée et de descente du signal transmis se répercute par une amélioration sensible de la bande passante de transmission du bus. Il est à noter aussi que les éléments additionnels du dispositif de l'invention peuvent être en grande partie communs à d'autres inverseurs ou d'autres composants du circuit intégré.

Il est clair que l'invention peut s'appliquer à d'autres composants qu'un inverseur. Par exemple, ses qualités peuvent profiter à un générateur d'horloge. Grâce à l'invention, les temps de montée et de descente sont réduits et constants, indépendamment des dérives. L'horloge peut être plus rapide et les temps d'attente d'un évènement (skew) plus courts. Il est aussi évident que l'invention peut s'appliquer en MOS simple, en CMOS et en BiCMOS. Dans ce dernier cas, les effets de l'invention seront amplifiés par l'action des transistors bipolaires, puisque le courant fourni par chaque circuit de compensation 17 alimente la base d'un transistor bipolaire.

**Revendications**

1. Procédé de compensation de la dérive du courant d'un transistor à effet de champ (P1) dans un circuit intégré (12), caractérisé en ce qu'il consiste à produire un signal de référence (Ra) représentatif de la conduction d'un transistor de référence (P2) du circuit intégré, à définir un seuil de conduction (Tt, Tf), à comparer le signal de référence avec le seuil de conduction, et à produire un courant de compensation si le signal de référence n'atteint pas le seuil de conduction.

2. Procédé selon la revendication 1, caractérisé en ce que la production du courant de compensation consiste à ajouter un courant au courant du transistor à effet de champ.

3. Procédé selon la revendication 1, caractérisé en ce que la production du courant de compensation consiste à sélectionner un trajet produisant ce courant.

4. Dispositif de compensation (10) de la dérive du courant d'un transistor à effet de champ (P1) dans un circuit intégré (12) mettant en oeuvre le procédé défini par l'une des revendications 1 à 3, caractérisé en ce qu'il comprend : un commutateur (16) ; et un circuit de compensation (17) comprenant au moins un chemin de courant (Pt, Pf) parallèle à celui du transistor à effet de champ (P1) et sélectionné par le commutateur.

5. Dispositif selon la revendication 4, caractérisé en ce que le commutateur (16) comprend au moins une liaison physique (16t, 16f) pouvant être fermée par laser par exemple.

6. Dispositif selon la revendication 4, caractérisé en ce que le commutateur (16) comprend au moins un interrupteur électronique (16t, 16f).

7. Dispositif selon la revendication 6, caractérisé en ce que le commutateur (16) est commandé par un générateur d'un signal de compensation (St, Sf).

8. Dispositif selon la revendication 7, caractérisé en ce que le générateur de signal de compensation est une mémoire ou un registre du circuit intégré (12).

9. Dispositif selon la revendication 7, caractérisé en ce que le générateur du signal de compensation est un amplificateur à seuil (15) recevant un signal de référence (Ra) représentatif de la conduction d'un transistor de référence (P2) du circuit intégré.

10. Circuit intégré (12), caractérisé en ce qu'il inclut un dispositif de compensation (10) tel que décrit dans les revendications 4 à 9.

FIG.1

FIG. 2

Office européen
des brevets

**RAPPORT DE RECHERCHE EUROPEENNE**

Numero de la demande

EP 90 40 3492

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | EP-A-0 256 729 (KABUSHIKI KAISHA TOSHIBA) * figures 1,2; colonne 2, ligne 52 - colonne 5, ligne 4 * --- | 1,4,7 | H 03 F 1/30 |
| A | US-A-4 446 444 (R.B. PATTERSON) * figure 1; colonne 2, ligne 43 - colonne 4, ligne 7 * --- | 2,4 | |
| A | US-A-4 806 875 (G.L. SCHAFFER) * figure 1; revendications 1,3 * --- | 8 | |
| A | DE-A-2 550 107 (HITACHI) * figure 6; page 4; page 9, lignes 2-4 * --- | | |
| A | GB-A-1 460 605 (RCA) * figure 5; page 5, lignes 1-71 * --- | | |
| A | DE-A-3 119 516 (SIEMENS) * figure 4; page 11, ligne 17 - page 14, ligne 13 * --- | | DOMAINES TECHNIQUES RECHERCHES (Int. Cl.5) H 03 F |
| A | US-A-4 785 258 (A.L. WESTWICK) * figure 2; colonne 4, ligne 59 - colonne 5, ligne 65 * ----- | | |

Le présent rapport a été établi pour toutes les revendications

| Lieu de la recherche | Date d'achèvement de la recherche | Examinateur |
|---|---|---|
| BERLIN | 06-03-1991 | BREUSING J |